(19) Europäisches Patentamt
European Patent Office
Office européen des brevets

(11) Veröffentlichungsnummer: **0 050 806**
**B1**

(12) # EUROPÄISCHE PATENTSCHRIFT

(45) Veröffentlichungstag der Patentschrift: **29.01.86**

(51) Int. Cl.⁴: **G 03 F 7/08**

(21) Anmeldenummer: **81108389.8**

(22) Anmeldetag: **16.10.81**

(54) **Lichtempfindliches Gemisch und damit hergestelltes lichtempfindliches Kopiermaterial.**

(30) Priorität: **24.10.80 DE 3040157**

(43) Veröffentlichungstag der Anmeldung:
**05.05.82 Patentblatt 82/18**

(45) Bekanntmachung des Hinweises auf die Patenterteilung:
**29.01.86 Patentblatt 86/5**

(84) Benannte Vertragsstaaten:
**AT BE CH DE FR GB LI NL**

(56) Entgegenhaltungen:
**DE-A-1 904 764**
**DE-A-2 405 831**
**US-A-3 046 118**
**US-A-3 106 465**
**US-A-4 174 222**

(73) Patentinhaber: **HOECHST AKTIENGESELLSCHAFT, Postfach 80 03 20, D-6230 Frankfurt am Main 80 (DE)**

(72) Erfinder: **Buhr, Gerhard, Dr., Am Erdbeerstein 28, D-6240 Königstein/Ts. 4 (DE)**
Erfinder: **Ruckert, Hans, Dr., Erbsenacker 21, D-6200 Wiesbaden (DE)**
Erfinder: **Stahlhofen, Paul, Dr., Leibnizstrasse 18/B, D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die Erfindung betrifft ein positiv arbeitendes lichtempfindliches Gemisch, das ein wasserunlösliches, in wässrig-alkalischen Lösungen lösliches oder quellbares harzartiges Bindemittel und einen 1,2-Naphthochinon-2-diazid-sulfonsäureester eines Dihydroxyacylophenons enthält.

Gemische der angegebenen Gattung sind aus der DE-PS 938 233 bekannt. Dort werden Naphthochinondiazidsulfonsäureester von substituierten mehrwertigen Phenolen beschrieben, die stets mindestens eine freie unveresterte Hydroxygruppe enthalten. Verbindungen dieser Art ergeben eine relativ niedrige Druckauflage und Entwicklerresistenz. Ausserdem lassen sich die partiell veresterten Verbindungen normalerweise nicht in reiner Form, sondern nur als Gemische der möglichen Isomeren und von Produkten unterschiedlichen Veresterungsgrades erhalten. Lösungen dieser Gemische in organischen Lösungsmitteln können Veränderungen unterworfen sein, indem schwerer lösliche Bestandteile auskristallisieren und so die Beschichtung von Druckplatten oder Leiterplatten stören. In neuerer Zeit werden deshalb die vollständig veresterten Phenolderivate, insbesondere solche mit mehr als einer Naphthochinondiazidsulfonsäureestergruppe im Molekül, bevorzugt, da diese höhere Druckauflagen liefern und eine bessere Entwicklerresistenz aufweisen.

Derartige Verbindungen sind in der DE-OS 1 904 764 beschrieben. Diese Verbindungen, insbesondere der Tris-1,2-naphthochinon-2-diazidsulfonsäureester des 2,3,4-Trihydroxy-benzophenons, werden in neuerer Zeit wegen ihrer vorteilhaften Kopier- und Druckeigenschaften in grossem Massstab technisch verwendet. Sie haben jedoch den Nachteil einer relativ geringen Löslichkeit in organischen Lösungsmitteln, besonders in den in der Technik bevorzugten Glykolmonoethern und Esterlösungsmitteln.

Aus der JP-OS 51/139 402 ist es bekannt, Ester aus 3 Mol 1,2-Naphthochinon-2-diazid-sulfonsäuren und 1 Mol Gallussäurealkylestern in Kombination mit Novolaken für die Herstellung positiv arbeitender lichtempfindlicher Materialien, insbesondere von Photoresistschichten zu verwenden. Die dort beschriebenen Chinondiazide sollen sich durch hohe Lichtempfindlichkeit und gute Löslichkeit in organischen Lösungsmitteln auszeichnen. Obwohl die Löslichkeit im Vergleich zu den bisher für die Herstellung von Offsetdruckplatten bevorzugt verwendeten Chinondiaziden verbessert ist, reicht sie für viele Zwecke noch nicht aus.

Aufgabe der Erfindung war es, ein lichtempfindliches Gemisch der eingangs angegebenen Gattung vorzuschlagen, das in seinen druck- und kopiertechnischen Eigenschaften mit den besten bisher bekannten Gemischen dieser Art mindestens vergleichbar ist, dessen lichtempfindliche Verbindungen sich aber zusätzlich durch eine höhere Löslichkeit in organischen Lösungsmitteln auszeichnen und sich in einfacher Weise in chemisch einheitlicher Form herstellen lassen. Mit den lichtempfindlichen Gemischen hergestellte Druckformen sollten infolge erhöhter Oleophilie fette Farbe gut annehmen. Die Struktur der lichtempfindlichen Verbindungen in diesen Gemischen sollte in einfacher Weise variierbar und somit den verschiedensten Anwendungszwecken anzupassen sein.

Die Erfindung geht aus von einem lichtempfindlichen Gemisch, das ein wasserunlösliches, in wässrig-alkalischen Lösungen lösliches oder mindestens quellbares Bindemittel und einen 1,2-Naphthochinon-2-diazid-sulfonsäureester eines Dihydroxyacylophenons enthält.

Die Aufgabe wird dadurch gelöst, dass der Ester der Formel I

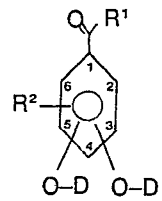

I

entspricht, worin

$R^1$ einen Alkylrest bedeutet, dessen Kohlenstoffkette durch Ethersauerstoffatome unterbrochen sein kann,

$R^2$ ein Wasserstoffatom, einen Alkylrest mit 1–3 Kohlenstoffatomen, ein Chlor- oder Bromatom, bevorzugt ein Wasserstoffatom und

D einen 1,2-Naphthochinon-2-diazid-sulfonylrest

bedeutet.

Erfindungsgemäss wird ferner ein lichtempfindliches Kopiermaterial, insbesondere für die Herstellung von Druckplatten und Photoresists, vorgeschlagen, das aus einem Schichtträger und einer lichtempfindlichen Schicht besteht, die ein wasserunlösliches, in wässrig-alkalischen Lösungen lösliches oder quellbares harzartiges Bindemittel und einen 1,2-Naphthochinon-2-diazidsulfonsäureester eines Dihydroxyacylophenons enthält, und das dadurch gekennzeichnet ist, dass der Sulfonsäureester der Formel I

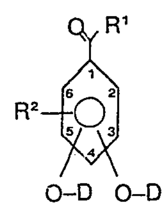

I

entspricht, worin

$R^1$ einen Alkylrest bedeutet, dessen Kohlenstoffkette durch Ethersauerstoffatome unterbrochen sein kann,

$R^2$ ein Wasserstoffatom, einen Alkylrest mit 1–3 Kohlenstoffatomen, ein Chlor- oder Bromatom, bevorzugt ein Wasserstoffatom und

D einen 1,2-Naphthochinon-2-diazid-sulfonylrest

bedeutet.

Die in dem erfindungsgemässen Gemisch enthaltenen Naphthochinondiazid-Verbindungen sind neu. Hergestellt werden sie nach bekannten Verfahren durch Veresterung der entsprechenden Dihydroxyverbindungen mit reaktiven Naphthochinondiazidsulfonsäurederivaten, z.B. dem Säurechlorid. Als bevorzugte Verfahren kommen die Umsetzungen in inerten Lösungsmitteln, wie Ketonen, Estern oder chlorierten Kohlenwasserstoffen, in Gegenwart tertiärer Amine, wie Pyridin, Dimethylanilin oder Triäthylamin, in Betracht. Die Naphthochinondiazidsulfonsäureester können jedoch auch in organisch-wässrigen Lösungen, z.B. in Gemischen von Dioxan oder Aceton mit wässriger Sodalösung bzw. Natriumhydrogencarbonatlösung, hergestellt werden.

Die Dihydroxyacylophenone erhält man zweckmässigerweise, wie in Houben-Weyl, Methoden der organischen Chemie, Bd. VII/2a, S. 47 und 281 ff, beschrieben, durch C-Acylierung von Dihydroxybenzolen, indem man diese mit Carbonsäuren oder reaktiven Carbonsäurederivaten in Gegenwart von Friedel-Crafts-Katalysatoren, zweckmässig in einem Verdünnungsmittel, umsetzt. Als Katalysatoren haben sich Aluminiumchlorid, Zinkchlorid, Bortrifluorid, Fluorwasserstoff, Perchlorsäure und auch Polyphosphorsäure bewährt. Verdünnungsmittel sind z.B. Schwefelkohlenstoff, 1,2-Dichlor-ethan, Chlorbenzol oder Nitrobenzol. Eine vorteilhafte Herstellungsmethode der Dihydroxyacylophenone besteht auch darin, dass man ein Säurehalogenid mit dem Dihydroxybenzol reagieren lässt und erst anschliessend in Gegenwart von Aluminiumchlorid weiter umsetzt.

Bevorzugte Verbindungen der Formel I sind Abkömmlinge von 2,4-Dihydroxy-acylophenonen, in denen $R_1$ eine Alkylgruppe mit 4–17, insbesondere mit 7–12 Kohlenstoffatomen und $R_2$ ein Wasserstoffatom bedeutet.

Die Sulfonsäureestergruppe der 1,2-Naphthochinon-2-diazidderivate steht im allgemeinen in der 4- oder 5-Stellung des Naphthochinondiazids, die 5-Sulfonsäureester werden bevorzugt.

Ausser den in den Beispielen genannten Verbindungen können z.B. die Bis-1,2-naphthochinon-2-diazid-4- und insbesondere -5-sulfonsäureester der folgenden Dihydroxyacylophenone eingesetzt werden:

2,5-Dihydroxy-1-(3-methyl-butanoyl)-benzol,
2,4-Dihydroxy-1-(4-methyl-pentanoyl)-benzol,
2,5-Dihydroxy-1-octanoyl-benzol,
2,4-Dihydroxy-1-decanoyl-benzol,
2,4-Dihydroxy-1-(3,5,5-trimethyl-hexanoyl)-benzol.

Weiterhin können eingesetzt werden 2,5-Dihydroxy-4-methyl- oder -4-propyl-1-hexadecanoylbenzol.

Die Konzentration der neuen Naphthochinondiazidsulfonsäureester in der lichtempfindlichen Schicht kann in relativ weiten Grenzen schwanken. Im allgemeinen liegt der Anteil bei 3 bis 50, vorzugsweise zwischen 7 und 35%, bezogen auf das Gewicht der nichtflüchtigen Anteile des lichtempfindlichen Gemischs. Gegebenenfalls kann im Rahmen dieser Mengenbereiche auch ein Teil der neuen Naphthochinondiazidderivate durch eine entsprechende Menge eines bekannten Naphthochinondiazids ersetzt werden, doch sollte bevorzugt der Mengenanteil der neuen Verbindung überwiegen.

Die erfindungsgemässen lichtempfindlichen Gemische enthalten ferner ein polymeres, wasserunlösliches harzartiges Bindemittel, das sich in den für das erfindungsgemässe Gemisch verwendeten Lösungsmitteln löst und in wässrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemässen Gemischen mit den neuen Naphthochinondiazidsulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Die Art und Menge der Novolak-Harze kann je nach Anwendungszweck verschieden sein; bevorzugt sind Novolak-Anteile am Gesamtfeststoff zwischen 95 und 50, besonders bevorzugt von 90–65 Gew.-%. Zusätzlich können noch zahlreiche andere Harze mitverwendet werden, bevorzugt Vinylpolymerisate wie Polyvinylacetate, Polyacrylate, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluss auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag etc. ausserdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten. Als weitere alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone, wie Methylethylketon, chlorierte Kohlenwasserstoffe wie Trichlorethylen und 1,1,1-Trichlorethan, Alkohole wie N-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z.B. mit Polyvinylphosphonsäure, Silikaten oder Phosphaten, vorbehandelt sein kann, ausserdem Mehrmetallplatten mit Cu/Cr oder Messing/Cr als oberster Schicht. Für die Herstellung von Hochdruckplatten können die erfindungsgemässen Gemische auf Zink- oder Magnesiumplatten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Gemische durch ihre gute Haftung und Ätzfestigkeit auf Kupfer- und Nickel-Oberflächen. Ebenso lassen sich die erfindungsgemässen Gemische als Photoresists in der Leiterplattenfertigung und beim Formteilätzen verwenden.

Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür und für Farbprüffolien werden Polyesterfolien, z.B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag. Schliesslich kann die Beschichtung von z.B. Leiterplatten, Glas oder Keramik und Silicium-Scheiben auch durch Schichtübertragung von einem temporären Träger erfolgen.

Belichtet wird mit den in der Technik üblichen Lichtquellen. Auch das Bestrahlen mit Elektronen stellt eine Möglichkeit zur Bebilderung dar.

Die zum Entwickeln verwendeten wässrig-alkalischen Lösungen abgestufter Alkalität, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemässen lichtempfindlichen Gemische bei der Herstellung von Druckformen, insbesondere Offset-, autotypischen Tiefdruck- und Siebdruckformen, in Kopierlacken und sogenannten Trockenresists.

Die unter Verwendung der neuen Verbindungen hergestellten Druckplatten besitzen eine hohe praktische Lichtempfindlichkeit sowie eine verbesserte Resistenz gegenüber alkalischen Entwicklern. Die bevorzugten Verbindungen selbst zeichnen sich durch eine gute bis hervorragende Löslichkeit in den üblichen organischen Lösungsmitteln sowie durch eine gute Verträglichkeit mit den Bestandteilen der Kopierschicht aus.

Zur weiteren Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperatur erwärmt werden, wie es aus der britischen Patentschrift 1 154 749 bekannt ist.

Im folgenden werden Beispiele für das erfindungsgemässe Gemisch angegeben. Dabei wird zuerst eine Anzahl neuer Bis-(1,2-naphthochinon-2-diazid-sulfonsäureester) von Dihydroxyacylophenonen in der Tabelle 1 aufgelistet, die in erfindungsgemässen Gemischen als lichtempfindliche Komponenten erprobt wurden. Die Numerierung der neuen Verbindungen von 1 bis 9 wird in den Anwendungsbeispielen beibehalten. Prozent- und Mengenverhältnisse sind, wenn nicht anders angegeben, in Gewichtseinheiten zu verstehen. Gewichtsteile (Gt) und Volumteile (Vt) stehen im Verhältnis von g zu ccm.

Tabelle 1

Ketone der allgemeinen Formel I mit OD-Gruppen in 2- und 4-Stellung und $R^2 = H$. D ist ein 1,2-Naphthochinon-2-diazid-4- bzw. -5-sulfonylrest. Die Ziffern unter D kennzeichnen den Ort der Substitution.

| Verbindung | $R^1$ | D | % N ber. | % N gef. |
|---|---|---|---|---|
| 1 | Methyl | 5 | 9,1 | 9,1 |
| 2 | n-Butyl | 5 | 8,5 | 8,5 |
| 3 | Hept-3-yl | 5 | 8,0 | 8,0 |
| 4 | Hept-3-yl | 4 | 8,0 | 8,4 |
| 5 | 2,4,4-Trimethylpentyl | 5 | 7,85 | 7,9 |
| 6 | 2,4,4-Trimethylpentyl | 4 | 7,85 | 8,2 |
| 7 | n-Pentadecyl | 5 | 6,9 | 7,0 |
| 8 | n-Pentadecyl | 4 | 6,9 | 7,0 |
| 9 | n-Heptadecyl | 5 | 6,7 | 6,8 |

Tabelle 2

Ester der allgemeinen Formel I mit $R^2 = H$ und $R^1 = $ Alkoxy. D ist ein 1,2-Naphtochinon-2-diazid-4- bzw. -5-sulfonylrest. Die Ziffern in der Spalte unter D kennzeichnen die Stellung der Sulfonylgruppe im Naphthochinonkern, die Ziffern in der Spalte «Substitution» die Positionen der DO-Gruppen im Benzolkern der Formel I.

| Verbindung | $R^1$ | D | Substitution | % N ber. | % N gef. |
|---|---|---|---|---|---|
| 10 | Methoxy | 5 | 2,4 | 8,9 | 8,9 |
| 11 | i-Amyloxy | 4 | 2,4 | 8,1 | 7,8 |
| 12 | i-Amyloxy | 5 | 2,5 | 8,1 | 8,2 |
| 13 | i-Amyloxy | 5 | 3,4 | 8,1 | 8,2 |
| 14 | 2-Ethoxyethoxy | 5 | 3,4 | 8,1 | 8,1 |
| 15 | 2-Ethoxyethoxy | 4 | 3,4 | 8,1 | 8,0 |
| 16 | 2-Ethoxyethoxy | 5 | 3,5 | 8,1 | 8,0 |
| 17 | n-Dodecyloxy | 5 | 2,4 | 7,1 | 7,0 |
| 18 | n-Dodecyloxy | 5 | 3,5 | 7,1 | 7,2 |

Die gute Löslichkeit der neuen Bis-naphthochinondiazidderivate von Dihydroxyacylophenonen wurde durch vergleichende Versuche nachgewiesen, wobei die Vertreter vorteilhaft herausragen, die durch mittlere bis lange aliphatische Reste substituiert sind. Als Vergleich diente der in der Technik verbreitet eingesetzte, aber in der Löslichkeit nicht bei allen Anwendungen befriedigende Tris-1,2-naphthochinon-2-diazid-5-sulfonsäureester des 2,3,4-Trihydroxy-benzophenons (Verbindung V).

Jeweils 1 bis 4 g kristalline Diazoverbindung in 25 g Ethylenglykolmonomethylether, dem in der Beschichtungstechnologie wichtigsten Lösungsmittel, wurden 2 Stunden bei Raumtemperatur gerührt und weitere 70 Stunden ohne Rühren stehen gelassen, um die Kristallisation möglicher amorpher Anteile zu vervollständigen. Anschliessend wurde das Gemisch abgesaugt, der Filterrückstand nacheinander mit 10 ml Methanol und 10 ml Ether gewaschen, im Vakuum getrocknet und sein Gewicht bestimmt. Aus der Differenz zur eingesetzten Menge wurden die in Tabelle 3 angeführten Löslichkeiten in Ethylenglykolmonomethylether errechnet.

Tabelle 3
Löslichkeiten verschiedener Naphthochinondiazide

| Verbindung Nr. | Löslichkeit (%) |
|---|---|
| V | 1,0 |
| 1 | 1,03 |
| 2 | >10,7 [1] |
| 3 | >13,8 [1] |
| 4 | 4,3 |
| 5 | >10,7 [1] |
| 6 | 10,5 |

[1] 3 g der Verbindungen 2 und 5 bzw. 4 g der Verbindung 3 lösten sich klar in Ethylenglykolmonomethylether und zeigten auch nach 3 Tagen keinerlei Ausfällungen.

In einem weiteren häufig verwendeten Lösungsmittel, n-Butylacetat, wurden die folgenden Löslichkeiten ermittelt. Jeweils 1 g der kristallinen Diazoverbindung wurde in 25 g n-Butylacetat 2 Stunden gerührt. Dann erfolgte die Aufarbeitung wie in Beispiel 1.

Tabelle 4
Löslichkeiten verschiedener Naphthochinondiazide in Butylacetat

| Verbindung Nr. | Löslichkeit (%) |
|---|---|
| V | 0,50 |
| 7 | 1,03 |
| 8 | 1,75 |

Beispiel 1

Eine elektrolytisch aufgerauhte und anodisierte Aluminiumfolie wurde mit einer Beschichtungslösung, bestehend aus

6,3 Gt Kresol-Formaldehyd-Novolak (Schmelzbereich 105–120 °C nach DIN 53181),
1,2 GT Verbindung 2
0,07 Gt Kristallviolett-Base,
0,17 Gt 1,2-Naphthochinon-2-diazid-4-sulfonsäurechlorid,
0,25 Gt Maleinatharz (Schmelzbereich 135–145 °C, Säurezahl 15–25) und
92,01 Gt eines Gemisches von 3 Gt Ethylenglykolmonomethylether und 2 Gt Butylacetat

schleuderbeschichtet, so dass sich nach dem Trocknen ein Schichtgewicht von 2,5 g/m² ergab. Die beschichtete Druckplatte wurde durch ein Diapositiv unter einer 5 kW-Metallhalogenidlampe im Abstand von 110 cm 60 Sekunden belichtet und mit dem Entwickler der folgenden Zusammensetzung

5,5 Gt Natriummetasilikat × 9 $H_2O$,
3,4 Gt Trinatriumphosphat × 12 $H_2O$,
0,4 Gt Natriumdihydrogenphosphat, wasserfrei und
90,7 Gt Wasser

entwickelt, wobei die belichteten Schichtbereiche entfernt wurden. Ein Druckversuch mit einer so hergestellten Offsetdruckform wurde nach 150 000 Drucken immer noch einwandfreier Qualität abgebrochen. Ein ähnliches Ergebnis wurde erhalten, wenn die Verbindung 2 in obiger Rezeptur durch gleiche Mengen der Verbindungen 4, 5 oder 6 ersetzt wurde.

Beispiel 2

Zur Herstellung eines Positiv-Trockenresists wurden

11,15 Gt Novolak nach Beispiel 1,
2,79 Gt Vinylacetat-Crotonsäure-Mischpolymerisat (95:5) vom Molekulargewicht 100 000,
4,18 Gt eines Mischpolymerisats aus n-Hexylmethacrylat, Methylmethacrylat und Methacrylsäure (5:1:2) mit der Säurezahl 158,
1,86 Gt Polyethylenglykol, Molgewicht 2000,
2,79 Gt Epoxidharz mit dem Epoxyäquivalentgewicht 190,
4,32 Gt der Verbindung 4,
0,45 Gt 1,2-Naphthochinon-2-diazid-4-sulfonsäurechlorid und
0,06 Gt Kristallviolett in
46,50 Gt Ethylenglykolmonoethylether und
25,90 Gt Methylethylketon

gelöst. Damit wurde eine ca. 25 µm dicke, mit einer wässrigen Lösung von 10% Trichloressigsäure, 1% Polyvinylalkohol und 0,1% Netzmittel vorbehandelte Polyesterfolie beschichtet und getrocknet. Auf die ca. 20 µm dicke Resistschicht wurde dann eine Polyethylen-Deckfolie zum Schutz gegen Staub und Verkratzungen aufgebracht.

Zur Herstellung von Leiterplatten wurde die Positiv-Trockenresistfolie nach Abziehen der Deckfolie in einem handelsüblichen Laminator auf eine gereinigte ca. 35 µm dicke Kupferfolie laminiert, die auf einen Isolierstoffträger kaschiert war. Nach Abziehen der Trägerfolie, evtl. Nachtrocknen, ca. 3 Minuten Belichten mit dem in Beispiel

1 beschriebenen Gerät und ca. 2 Minuten Sprühentwickeln mit einem Entwickler der folgenden Zusammensetzung
0,6 Gt NaOH,
0,5 Gt Natriummetasilikat × 5 $H_2O$,
1,0 Gt n-Butanol und
97,9 Gt Wasser
wurde eine ausgezeichnete bildmässige Resistschicht erhalten. Sie widerstand nicht nur den Bedingungen von Ätzprozessen, z.B. mit $FeCl_3$, sondern war auch galvanoresistent bei der Herstellung durchkontaktierter Schaltungen, insbesondere bei dem galvanischen Aufbau von Kupfer, Nickel und Gold hintereinander.

Beispiel 3

Die Verbindung 3 wurde für die Herstellung einer Photoresistlösung eingesetzt, die zur Herstellung von sogenannten Formätzteilen verwendet wird.

Dazu wurden in 67,9 Gt 2-Butanon gelöst:
12,0 Gt Novolak nach Beispiel 1,
5,0 Gt Polyethylacrylatlösung (40% in Toluol, Plexisol B 574, Fa. Röhm),
5,0 Gt Polyvinylethylether, niedrigviskos,
7,0 Gt Verbindung 3,
3,0 Gt Vinylacetat-Crotonsäure-Mischpolymerisat nach Beispiel 2 und
0,1 Gt Kristallviolett.

Damit wurde für die rationelle Produktion von Kleinteilen für elektrische Schalter ein ca. 0,5 mm dickes Blech aus einer speziellen Kupferlegierung anstatt durch mechanisches Stanzen wie folgt verarbeitet: Das Blech wurde durch Tauchen in obige Lösung beidseitig beschichtet, getrocknet, beidseitig mit zueinander deckungsgleichen positiven Filmvorlagen des gewünschten Formteils belichtet, wässrig-alkalisch entwickelt und beidseitig durch Sprühen z.B. mit Ferrichlorid-Lösung geätzt. Wenn das Bild des Metallteils, z.B. einer Federzunge, im Nutzen, d.h. in grösserer Zahl in einem Arbeitsgang kopiert wird, lohnt sich diese Formätztechnik besonders. Zweckmässigerweise lässt man zwischen den einzelnen sich wiederholenden Mustern kleine Stege, damit zum Ende der Ätzung die einzelnen Teile noch zusammenbleiben und erst nach dem Spülen mechanisch getrennt anfallen.

Die beschriebene Kopierlackschicht mit diesen speziellen Diazo-Verbindungen ist ausgezeichnet durch vielseitige Verwendbarkeit auf zahlreichen verschiedenen Metalloberflächen. Sie zeigt gute Haftung und sichere Kopiereigenschaften sowie Ätzfestigkeit gegen zahlreiche Ätzlösungen, die je nach Legierung noch Schwefelsäure, Fluorwasserstoffsäure, Chromsäure, Wasserstoffperoxyd u.a. enthalten können.

Beispiel 4

Eine Lösung von
3,1 Gt der Verbindung 2,
21,0 Gt Phenol-Formaldehyd-Novolak mit dem Schmelzbereich 110–120 °C (nach Kapillarmethode DIN 53181),
3,5 Gt Epoxidharz (Epoxyäquivalentgewicht um 450) und
0,4 Gt Sudanblau II (C.I. Solvent Blue 35), in
50,0 Gt Ethylenglykolmonoethyletheracetat,
12,0 Gt Ethylenglykolmonoethylether und
10,0 Gt Butylacetat
ergab einen Positiv-Kopierlack, der sich für die Fertigung von Leiterplatten, von Kupfertiefdruckzylindern oder für Nickelgalvanoschablonen eignete.

Entwickelt wurde mit dem Entwickler aus Beispiel 2, der bei Bedarf mit Wasser verdünnt wurde.

Anstelle der Verbindung 2 konnte mit gleichem Ergebnis die Verbindung 3 verwendet werden.

Beispiel 5

Es wurden
1,18 Gt der Verbindung 7,
5,70 Gt Novolak nach Beispiel 1,
0,40 Gt 2,3,4-Trihydroxy-benzophenon,
0,10 Gt 4-(p-Tolylmercapto)-2,5-diethoxy-benzol-diazoniumhexafluorophosphat und
0,06 Gt Kristallviolett
in einem Lösungsmittelgemisch aus
52,6 Gt Ethylenglykolmonomethylether und
40,0 Gt Tetrahydrofuran
gelöst. Mit dieser Lösung wurde eine elektrolytisch aufgerauhte und anodisierte und mit einer wässrigen Lösung von Polyvinylphosphonsäure behandelte Aluminiumplatte beschichtet. Die mit dieser Platte entsprechend Beispiel 3 hergestellte Offsetdruckform war für den Hochauflagenbereich geeignet. Die Druckschicht zeichnete sich durch hervorragende Farbannahme aus. Ähnliche Ergebnisse wurden erhalten, wenn statt der Verbindung 7 gleiche Gewichtsteile der Verbindungen 8 oder 9 eingesetzt wurden.

Beispiel 6

Zur Herstellung mikroelektronischer Schaltelemente hoher Packungsdichte wurde eine käufliche, wie üblich polierte und durch Oxydation mit einer 0,2 µm dicken $SiO_2$-Schicht versehene Siliciumscheibe mit folgendem Positiv-Kopierlack beschichtet.

In 70 Gt eines Lösungsmittelgemisches aus Ethylenglykolethyletheracetat, Butylacetat und Xylol (8:1:1 Vt) wurden
18 Gt Novolak nach Beispiel 1 und
4 Gt Verbindung 2
gelöst und durch ein 0,5 µm-Filter filtriert.

Durch Schleuderbeschichten des Trägers wurde bei 9000 U/min eine Resistschicht von ungefähr 0,9 µm Dicke erhalten, die noch 10 Minuten bei 90 °C im Umluftschrank getrocknet wurde. Nach dem Abkühlen und Konditionieren auf ein definiertes Raumklima von 23 °C und 40–50% relativer Feuchte wurde in einem Wafer-Kontaktbelichtungsgerät unter einer handelsüblichen Chrommaske mit hochaufgelösten Testfeldern mit einer 200 Watt Hg-Hochdrucklampe etwa 6 Sekunden belichtet.

Entwickelt wurde bei 25 °C in einem bewegten Entwickler, bestehend aus

2,67% Natriummetasilikat × 9 Wasser,
1,71% Trinatriumphosphat × 12 Wasser,
0,17% Natriumdihydrogenphosphat,
gelöst in
95,45% Wasser.

Anschliessend wurde mit Wasser gespült und mit Stickstoff trocken geblasen.

Testelemente von 2 µm Breite und Abstand wurden vorlagengetreu abgebildet.

**Patentansprüche**

1. Lichtempfindliches Gemisch, enthaltend ein wasserunlösliches, in wässrig-alkalischen Lösungen lösliches oder quellbares harzartiges Bindemittel und einen 1,2-Naphthochinon-2-diazid-sulfonsäureester eines Dihydroxyacylophenons, dadurch gekennzeichnet, dass der Sulfonsäureester der Formel I

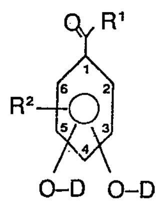

I

entspricht, worin

$R^1$ einen Alkylrest bedeutet, dessen Kohlenstoffkette durch Ethersauerstoffatome unterbrochen sein kann,

$R^2$ ein Wasserstoffatom, einen Alkylrest mit 1–3 Kohlenstoffatomen, ein Chlor- oder Bromatom und

D einen 1,2-Naphthochinon-2-diazid-sulfonylrest

bedeuten.

2. Lichtempfindliches Gemisch nach Anspruch 1, dadurch gekennzeichnet, dass es eine Verbindung der Formel I enthält, in der

$R^2$ ein Wasserstoffatom und

D einen 1,2-Naphthochinon-2-diazid-4- oder -5-sulfonylrest

bedeutet.

3. Lichtempfindliches Gemisch nach Anspruch 1, dadurch gekennzeichnet, dass es eine Verbindung der Formel I enthält, in der $R^1$ einen Alkylrest mit 4 bis 17 Kohlenstoffatomen bedeutet.

4. Lichtempfindliches Gemisch nach Anspruch 1, dadurch gekennzeichnet, dass das Bindemittel ein Phenolharz ist.

5. Lichtempfindliches Gemisch, dadurch gekennzeichnet, dass es, bezogen auf seine nichtflüchtigen Bestandteile, 3 bis 50 Gew.-% an Verbindungen der Formel I enthält.

6. Lichtempfindliches Kopiermaterial, bestehend aus einem Schichtträger und einer lichtempfindlichen Schicht die ein wasserunlösliches, in wässrig-alkalischen Lösungen lösliches oder quellbares harzartiges Bindemittel und einen 1,2-Naphthochinon-2-diazid-sulfonsäureester eines Dihydroxyacylophenons enthält, dadurch gekennzeichnet, dass der Sulfonsäureester der Formel I

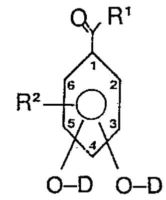

I

entspricht, worin

$R^1$ einen Alkylrest bedeutet, dessen Kohlenstoffkette durch Ethersauerstoffatome unterbrochen sein kann,

$R^2$ ein Wasserstoffatom, einen Alkylrest mit 1 bis 3 Kohlenstoffatomen, ein Chlor- oder Bromatom und

D einen 1,2-Naphthochinon-2-diazid-sulfonylrest

bedeutet.

**Claims**

1. A light-sensitive mixture which contains a water-insoluble resinous binder, which is soluble or swellable in aqueous-alkaline solutions, and a 1,2-naphthoquinone-2-diazide-sulfonic acid ester of a dihydroxyacylophenone, wherein the sulfonic acid ester corresponds to the formula I

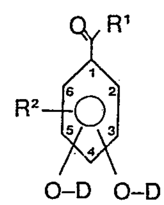

I

in which $R^1$ is an alkyl radical, the carbon chain of which can be interrupted by ether oxygen atoms; $R^2$ is a hydrogen atom, an alkyl radical having 1–3 carbon atoms, or a chlorine or bromine atom; and D is a 1,2-naphthoquinone-2-diazide-sulfonyl radical.

2. A light-sensitive mixture as claimed in claim 1, which contains a compound of the formula I, in which $R^2$ is a hydrogen atom and D is a 1,2-napthoquinone-2-diazide-4- or -5-sulfonyl radical.

3. A light-sensitive mixture as claimed in claim 1, which contains a compound of the formula I, in which $R^1$ is an alkyl radical having 4–17 carbon atoms.

4. A light-sensitive mixture as claimed in claim 1, wherein the binder is a phenolic resin.

5. A light-sensitive mixture, which contains 3–50% by weight, relative to its non-volatile constituents, of compounds of the formula I.

6. A light-sensitive copying material, composed of a support and a light-sensitive layer which contains a water-insoluble resinous binder, which is soluble or swellable in aqueous-alkaline solutions, and a 1,2-naphthoquinone-2-diazide-sulfonic acid ester of a dihydroxyacylophenone, wherein the sulfonic acid ester corresponds to the formula I

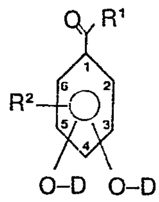

I

in which $R^1$ is an alkyl radical, the carbon chain of which can be interrupted by ether oxygen atoms; $R^2$ is a hydrogen atom, an alkyl radical having 1–3 carbon atoms, or a chlorine or bromine atom; and D is a 1,2-naphthoquinone-2-diazide-sulfonyl radical.

**Revendications**

1. Mélange sensible à la lumière, contenant un liant résineux insoluble dans l'eau, soluble ou gonflable dans des solutions alcalines aqueuses et un ester de dihydroxyacylophénone et l'acide 1,2-naphtoquinone-2-diazide-sulfonique, caractérisé en ce que l'ester de l'acide sulfonique correspond à la formule I

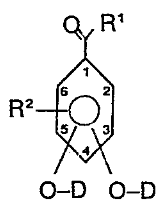

I

dans laquelle

$R^1$ représente un groupe alcoyle dont la chaîne carbonée peut être interrompue par des atomes d'oxygène d'éther,

$R^2$ représente un atome d'hydrogène, un groupe alcoyle ayant de 1 à 3 atomes de carbone, un atome de chlore ou de brome, et

D représente un groupe 1,2-naphtoquinone-2-diazidesulfonyle.

2. Mélange sensible à la lumière selon la revendication 1, caractérisé en ce qu'il contient un composé de formule I, dans lequel

$R^2$ représente un atome d'hydrogène, et

D représente un groupe 1,2-naphtoquinone-2-diazide-4- ou -5-sulfonyle.

3. Mélange sensible à la lumière selon la revendication 1, caractérisé en ce qu'il contient un composé de formule I, dans lequel $R^1$ est un groupe alcoyle ayant de 4 à 17 atomes de carbone.

4. Mélange sensible à la lumière selon la revendication 1, caractérisé en ce que le liant est une résine phénolique.

5. Mélange sensible à la lumière, caractérisé en ce qu'il contient de 3 à 50% en poids de composés de formule I, par rapport à ses constituants nonvolatils.

6. Matériau de reproduction sensible à la lumière, constitué d'un support de couche et d'une couche sensible à la lumière qui contient un liant résineux insoluble dans l'eau, soluble ou gonflable dans des solutions alcalines aqueuses, et un ester de dihydroxyacylophénone de l'acide 1,2-naphtoquinone-2-diazide-sulfonique, caractérisé en ce que l'ester de l'acide sulfonique correspond à la formule I

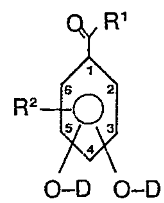

I

dans laquelle

$R^1$ représente un groupe alcoyle dont la chaîne carbonée peut être interrompue par des atomes d'oxygène d'éther,

$R^2$ représente un atome d'hydrogène, un groupe alcoyle ayant de 1 à 3 atomes de carbone, un atome de chlore ou de brome, et

D représente un groupe 1,2-naphtoquinone-2-diazide-sulfonyle.